# EUROPEAN PATENT SPECIFICATION

(11) **EP 3 193 365 B1**
(45) Date of publication and mention of the grant of the patent: **21.07.2021**
(21) Application number: 16165442.1
(22) Date of filing: 14.04.2016
(51) Int. Cl.: H01L 23/38, G06F 1/20, H01L 23/427

(54) **HEAT DISSIPATION SYSTEM**
WÄRMEABLEITUNGSSYSTEM
SYSTÈME DE DISSIPATION DE CHALEUR

(30) Priority: 13.01.2016 TW 105101004
(43) Date of publication of application: 19.07.2017
(73) Proprietor: MSI Computer (Shenzhen) Co., Ltd., Shenzhen City Guangdong Province, P.R.C. Guangdong (CN)
(72) Inventor: CHEN, Cheng-Lung, Taoyuan City, (TW); CHANG, Chia-Ming, Taipei City, (TW)
(74) Representative: Plasseraud IP

(56) References cited:
- US-A1- 2002 186 531
- US-A1- 2009 034 202
- US-A1- 2010 328 878
- US-B1- 6 415 612
- US-B1- 6 525 934
- None

## Description

### Technical Field

The disclosure relates to a heat dissipation system, more particularly to a heat dissipation system equipped with a thermoelectric cooler.

### Background

Electronic products such as tablet computers or notebook computers have been developed to be more powerful because electronic components, such as high performance central processing unit (CPU) and high performance graphics processing unit (GPU), are provided therein. However, the high performance electronic components require lots of energy to operate, which generates a large amount of heat. If the heat is not removed, the performance of the electronic components will be degraded by overheating and thereby causing the electronic components to shutdown. Accordingly, a heat dissipation module is provided for cooling the heat source (e.g. the CPU). In some specific electronic products, the heat dissipation modules is additionally equipped with a thermoelectric cooler (TEC) for improving cooling efficiency.

The TEC is usually directly disposed on the CPU, and thus a large amount of heat generated by the CPU will be directly transferred to the TEC. In such a case, the TEC requires lots of energy for effectively cooling the CPU, which results in high energy consumption. In addition, the temperature of the CPU will be increased by waste heat generated by the thermoelectric cooler during the thermoelectric cooler operated in high power mode, thereby decreasing cooling efficiency. Hence, an additional large size heat dissipation module is needed for removing the waste heat, but the additional large size heat dissipation module is unfavorable for developing compact electronic products

US 6 415 612 B1 (POKHARNA HIMANSHU [US] ET AL) 9 July 2002 (2002-07-09) discloses the cooling of a CPU via a remote TEC.

### SUMMARY

The present disclosure provides a heat dissipation system for solving the problem that the traditional heat dissipation module is high in energy consumption and large in size.

One embodiment of the disclosure provides a heat dissipation system including a first heat dissipation module, a second heat dissipation module and a thermoelectric cooler. The first heat dissipation module is in thermal contact with at least one heat source. The second heat dissipation module includes a fan and a heat sink. The fan of the second heat dissipation module is disposed on the heat sink. The thermoelectric cooler is spaced apart from the at least one heat source and is in thermal contact with the at least one heat source through the first heat dissipation module. The heat sink of the second heat dissipation module is in thermal contact with the thermoelectric cooler.

According to the heat dissipation system as discussed above, since the thermoelectric cooler is spaced apart from the at least one heat source and is in thermal contact with the at least one heat source through the first heat dissipation module, the heat source is indirectly in thermal contact with the thermoelectric cooler but is directly in thermal contact with the first heat dissipation module. Thus, the thermoelectric cooler can be turned on or off according to a predetermined threshold temperature. For example, before the temperature of the heat source reaches the predetermined threshold temperature, the electronic components mainly rely on the first heat dissipation modules to remove heat generated by the heat source, the thermoelectric cooler and the second heat dissipation module for cooling the thermoelectric cooler will not be turned on and require no energy. Hence, the amount of energy for cooling the heat source is reduced.

In addition, since the thermoelectric cooler is indirectly in thermal contact with the heat source, a preset temperature of triggering the thermoelectric cooler is no need to be set too low. Thus, the thermoelectric cooler is prevented from being operated too often and too long during cooling the heat source, which consumes less energy.

Moreover, the second heat dissipation module for cooling the thermoelectric cooler is an active heat dissipation module, which is able to effectively cool the thermoelectric cooler. Therefore, the thermoelectric cooler requires less energy to operate so that waste heat generated by the thermoelectric cooler is reduced during operation and has less influence on the cooling efficiency. In addition, the heat dissipation system of the present disclosure has no need to be equipped with any additional large size heat dissipation module for removing the waste heat, which is favorable for developing light and thin electronic products.

### BRIEF DESCRIPTION OF THE DRAWINGS

The present disclosure will become more fully understood from the detailed description given hereinbelow and the accompanying drawings which are given by way of illustration only and thus are not limitative of the present disclosure and wherein:
FIG. 1 is a perspective view of a heat dissipation system disposed in an electronic product according to one embodiment of the disclosure; and
FIG. 2 is an exploded view of a second heat dissipation module according to one embodiment of the disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

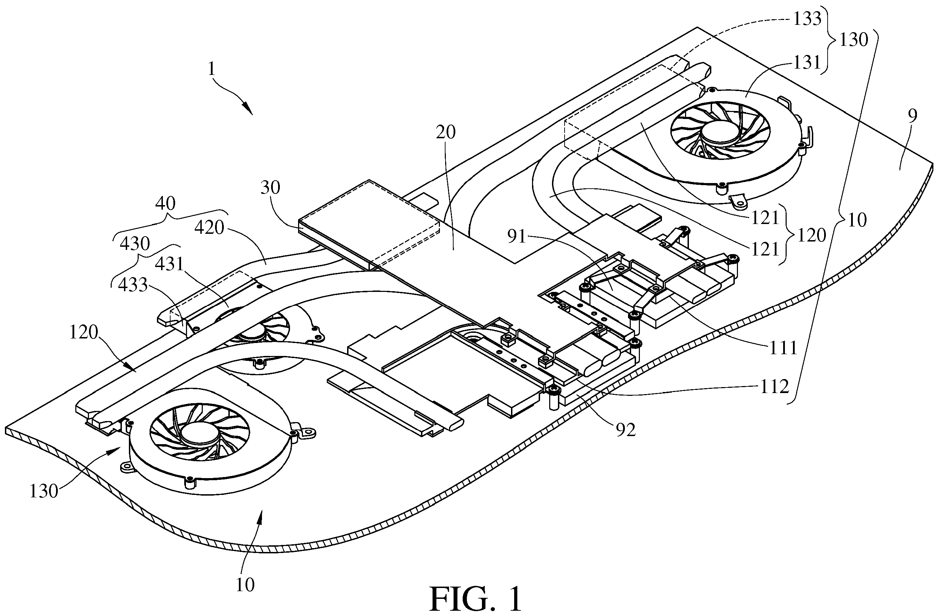

Please refer to FIG. 1, which is a perspective view of a heat dissipation system disposed in an electronic product according to one embodiment of the disclosure. As shown in FIG. 1, a heat dissipation system 1 is provided. The heat dissipation system 1 is, for example, adaptive to an electronic product such as a tablet computer or a notebook computer. The heat dissipation system 1 is for removing heat generated by electronic components such as CPU and GPU. As shown in FIG. 1, the heat dissipation system 1 is disposed in the electronic product 9 for removing heat generated by a heat source 91 and a heat source 92. The heat source 91 is a CPU, and the heat source 92 is a GPU, but the present disclosure is not limited thereto. In other embodiments, the heat source 91 may be the GPU, and the heat source 92 may be the CPU. In addition, the present disclosure is not limited to the quantity of the heat sources corresponding to the heat dissipation system 1. In other embodiments, the heat dissipation system 1 is adapted for removing heat generated by three heat sources or only one heat source.

In this embodiment, the heat dissipation system 1 includes two first heat dissipation modules 10, a heat conducting plate 20, a thermoelectric cooler 30 and a second heat dissipation module 40. Both of the two first heat dissipation modules 10 are active heat dissipation modules. The two first heat dissipation modules 10 are able to remove heat generated by the heat source 91 and the heat source 92. The second heat dissipation module 40 is in thermal contact with the thermoelectric cooler 30. The thermoelectric cooler 30 is in thermal contact with the two first heat dissipation modules 10 through the heat conducting plate 20. The thermoelectric cooler 30 is spaced apart from the heat sources 91 and 92. That is, the thermoelectric cooler 30 is indirectly in thermal contact with the heat sources 91 and 92.

In detail, taking the first heat dissipation module 10 at the right side of FIG. 1 as an example, the first heat dissipation module 10 includes a first heat absorbing member 111, a second heat absorbing member 112, a first heat conducting member 120 and a first heat dissipating assembly 130. Each of the first heat absorbing member 111 and the second heat absorbing member 112 is made of high thermal conductivity materials such as iron, aluminum or iron-aluminum alloy. The first heat absorbing member 111 is in thermal contact with the heat source 91 for absorbing heat generated thereby. The second heat absorbing member 112 is in thermal contact with the heat source 92 for absorbing heat generated thereby.

The first heat absorbing member 111 and the second heat absorbing member 112 are in thermal contact with the first heat dissipating assembly 130 through the first heat conducting member 120. That is, the first heat conducting member 120 is in thermal contact with both of the two heat absorbing members 111 and 112 and the first heat dissipating assembly 130. Specifically, in this embodiment, the first heat conducting member 120 includes a plurality of heat pipes 121. The first heat dissipating assembly 130 includes a first fan 131 and a first heat sink 133. The first fan 131 is, for example, a centrifugal fan disposed on the first heat sink 133. One end of the heat pipes 121 is in thermal contact with the first heat absorbing member 111 and the second heat absorbing member 112 by, for example, adhesion or welding. The other end of the heat pipes 121 is in thermal contact with the first heat sink 133 of the first heat dissipating assembly 130 by, for example, adhesion or welding. Thus, heat absorbed by the first heat absorbing member 111 and the second heat absorbing member 112 is able to be transferred to the first heat dissipating assembly 130 through the first heat conducting member 120 and then dissipated by the first heat dissipating assembly 130. The two first heat dissipation modules 10 share the same second heat absorbing member 112. However, the present disclosure is not limited to the quantity of the heat absorbing members. In other embodiments, the two first heat dissipation modules 10 can be equipped with only one heat absorbing member. In addition, the present is not limited to the quantity of the heat pipes 121. For example, please see the first heat dissipation module 10 at the left side of FIG. 1, the first heat conducting member 120 is equipped with only one heat pipe 121. Furthermore, the present disclosure is not limited to the quantity of the first heat dissipation modules 10. In other embodiments, the quantity of the first heat dissipation module 10 can be one, in such a case, the quantity of the first heat conducting member 120 can be one, and the quantity of the first heat dissipating assembly 130 can be one.

The heat conducting plate 20 is made of high thermal conductivity materials such as iron, aluminum or iron-aluminum alloy. In this embodiment, the heat conducting plate 20 is fixed onto the first heat absorbing member 111 and the second heat absorbing member 112 and in thermal contact with the first heat conducting members 120 of the two first heat dissipation modules 10. The thermoelectric cooler 30 is in thermal contact with the heat conducting plate 20 by, for example, adhesion or welding.

In this embodiment, the second heat dissipation module 40 is an active heat dissipation module and includes a second heat conducting member 420 and a second heat dissipating assembly 430. In detail, the second heat conducting member 420 includes a heat pipe. The second heat dissipating assembly 430 includes a second fan 431 and a second heat sink 433. The second fan 431 is disposed on the second heat sink 433. The second heat conducting member 420 is in thermal contact with the second heat sink 433 and the thermoelectric cooler 30 by, for example, adhesion or welding.

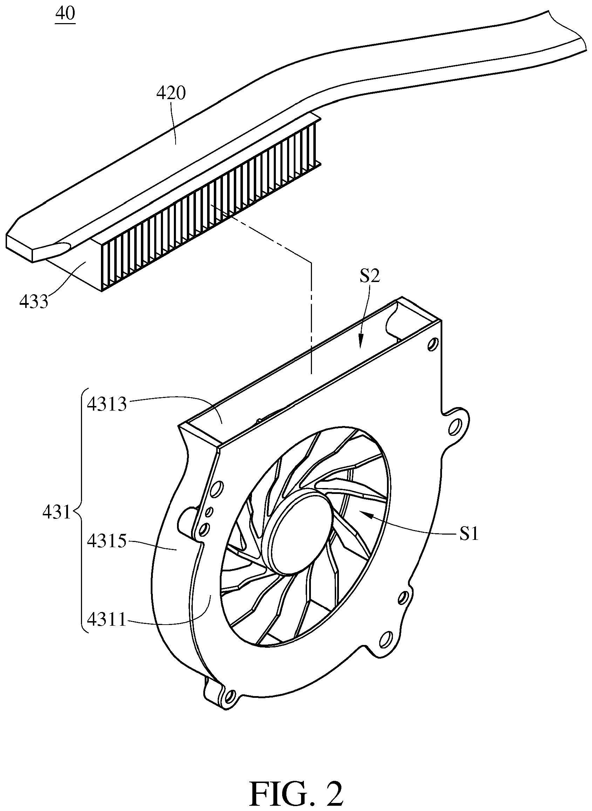

In detail, please refer to FIG. 2, which is an exploded view of a second heat dissipation module according to one embodiment of the disclosure. In this embodiment, the second fan 431 is a centrifugal fan. The second fan 431 includes a top plate 4311, a bottom plate 4313 and a side plate 4315. The side plate 4315 is connected between the top plate 4311 and the bottom plate 4313. The second fan 431 has an air inlet S1 and an air outlet S2. The air inlet S1 is on the top plate 4311. The air outlet S2 is on the side plate 4315. The second heat sink 433 is adjacent to the air outlet S2.

Please refer back to FIG. 1, when the electronic components (e.g. the heat source 91 and the heat source 92) are in operation, heat generated by the heat source 91 and the heat source 92 is removed by the two first heat dissipation modules 10 in the first place. In detail, heat generated by the heat source 91 and the heat source 92 is absorbed by the first heat absorbing member 111 and the second heat absorbing member 112 of the first heat dissipation module 10, transferred to the first heat dissipating assembly 130 through the first heat conducting member 120 and then dissipated by the first heat dissipating assembly 130.

The thermoelectric cooler 30 and the second heat dissipation module 40 can be turned on according to a specific circumstance. Specifically, before the temperature of the heat source 91 or 92 reaches a predetermined threshold temperature, the thermoelectric cooler 30 and the second heat dissipation module 40 will not be turned on. Under the circumstances, the heat source 91 and the heat source 92 are cooled by the two first heat dissipation modules 10. When the temperature of the heat source 91 or the heat source 92 reaches or exceeds the predetermined threshold temperature, the thermoelectric cooler 30 and the second heat dissipation module 40 will be turned on, for example, by a controller (not shown in the drawings). In such a case, heat absorbed by the first heat dissipation module 10 is able to be transferred to the thermoelectric cooler 30 through the heat conducting plate 20 and then dissipated by the second heat dissipation module 40, which increases cooling efficiency of the system so as to decrease the temperature of the heat sources effectively.

In other words, before the temperature of the heat source reaching the predetermined threshold temperature, the electronic components of the electronic product 9 mainly rely on the first heat dissipation modules 10 to dissipate heat generated thereby. Thus, the thermoelectric cooler 30 and the second heat dissipation module 40 for cooling the thermoelectric cooler 30 will not be turned on and require no energy. Hence, the amount of energy for cooling the heat sources is reduced.

In addition, in the heat dissipation system 1, the thermoelectric cooler 30 is spaced apart from the heat sources 91 and 92. That is, the thermoelectric cooler 30 is indirectly in thermal contact with the heat sources. A preset temperature of triggering the thermoelectric cooler is no need to be set too low so that the thermoelectric cooler 30 is prevented from being operated too often and too long during cooling the heat sources, which consumes less energy. Therefore, waste heat generated by the thermoelectric cooler 30 is reduced during operation and has less influence on the cooling efficiency. Hence, the second heat dissipation module 40 has no need to be designed large in size, which occupies less inner space of the electronic product 9.

It is noted that the said predetermined threshold temperature can be altered according to actual requirement.

According to the heat dissipation system discussed above, since the thermoelectric cooler is spaced apart from the at least one heat source and in thermal contact with the at least one heat source through the first heat dissipation module, the heat source is indirectly in thermal contact with the thermoelectric cooler but directly in thermal contact with the first heat dissipation module. Thus, the thermoelectric cooler can be turned on or off according to a predetermined threshold temperature. For example, before the temperature of the heat source reaching the predetermined threshold temperature, the electronic components mainly rely on the first heat dissipation modules to remove heat generated by the heat source, the thermoelectric cooler and the second heat dissipation module for cooling the thermoelectric cooler will not be turned on and require no energy. Hence, the amount of energy for cooling the heat source is reduced.

In addition, since the thermoelectric cooler is indirectly in thermal contact with the heat source, a preset temperature of triggering the thermoelectric cooler has no need to be set too low. Thus, the thermoelectric cooler is prevented from being operated too often and too long during cooling the heat source, which consumes less energy.

Moreover, the second heat dissipation module for cooling the thermoelectric cooler is an active heat dissipation module, which is able to effectively cool the thermoelectric cooler. Therefore, the thermoelectric cooler requires less energy to operate so that waste heat generated by the thermoelectric cooler is reduced during operation and has less influence on the cooling efficiency. In addition, the heat dissipation system of the present disclosure is not need to be equipped with any additional large size heat dissipation module for removing the waste heat, which is favorable for developing light and thin electronic products.

## Claims

1. A heat dissipation system (1), comprising:
at least one first heat dissipation module (10) comprising at least one first heat pipe (121), the at least one first heat pipe (121) having a first end and a second end opposite to each other, the first end being on and in thermal contact with at least one heat source (91, 92) and located closer to the at least one heat source (91, 92) than the second end;
a second heat dissipation module (40) comprising a fan (431) and a heat sink (433), the fan of the second heat dissipation module disposed next to the heat sink; and
a thermoelectric cooler (30) spaced apart from the at least one heat source (91, 92) and in direct contact with a heat conducting plate (20) which is in direct contact with the first end of the at least one first heat pipe (121), wherein the heat sink of the second heat dissipation module is in thermal contact with the thermoelectric cooler.

2. The heat dissipation system according to claim 1, wherein the at least one first heat dissipation module further comprises at least one heat absorbing member (111), a heat conducting member (112) and a heat dissipating assembly (130), the at least one heat absorbing member is in thermal contact with the at least one heat source, and the at least one heat absorbing member is in thermal contact with the heat dissipating assembly through the heat conducting member.

3. The heat dissipation system according to claim 2, wherein the heat dissipating assembly comprises a fan (131) and a heat sink (133), the heat sink of the heat dissipating assembly is in thermal contact with the heat conducting member of the at least one first heat dissipation module, and the fan of the heat dissipating assembly is disposed next to the heat sink of the heat dissipating assembly.

4. The heat dissipation system according to claim 2, wherein the at least one heat absorbing member of the at least one first heat dissipation module is made of iron, aluminum or iron-aluminum alloy.

5. The heat dissipation system according to claim 1, wherein the second heat dissipation module further comprises a heat conducting member (420), the heat conducting member of the second heat dissipation module is in thermal with the thermoelectric cooler, and the heat sink of the second heat dissipation module is in thermal contact with the thermoelectric cooler through the heat conducting member of the second heat dissipation module.

6. The heat dissipation system according to claim 5, wherein the heat conducting member of the second heat dissipation module comprises at least one heat pipe.

7. The heat dissipation system according to claim 1, wherein the fan of the second heat dissipation module is a centrifugal fan.

8. The heat dissipation system according to claim 7, wherein the fan of the second heat dissipation module comprises a top plate (4311), a bottom plate (4313) and a side plate (4315), the side plate is connected between the top plate and the bottom plate, the fan of the second heat dissipation module has an air inlet (S1) and an air outlet (S2), the air inlet is located on the top plate, the air outlet is located on the side plate, and the heat sink of the second heat dissipation module is adjacent to the air outlet.

## Patentansprüche

1. Wärmeableitungssystem (1), umfassend:
wenigstens ein erstes Wärmeableitungsmodul (10), welches wenigstens ein erstes Wärmerohr (121) umfasst, wobei das wenigstens eine erste Wärmerohr (121) ein erstes Ende und ein zweites Ende aufweist, welche zueinander entgegengesetzt sind, wobei das erste Ende an wenigstens einer Wärmequelle (91, 92) vorliegt und in thermischem Kontakt damit ist und näher an der wenigstens einen Wärmequelle (91, 92) angeordnet ist als das zweite Ende;
ein zweites Wärmeableitungsmodul (40), welches ein Gebläse (431) und eine Wärmesenke (433) umfasst, wobei das Gebläse des zweiten Wärmeableitungsmoduls neben der Wärmesenke angeordnet ist; und
einen thermoelektrischen Kühler (30), welcher von der wenigstens einen Wärmequelle (91, 92) beabstandet ist und in direktem Kontakt mit einer wärmeleitenden Platte (20) ist, welche in direktem Kontakt mit dem ersten Ende des wenigstens einen ersten Wärmerohrs (121) ist, wobei
die Wärmesenke des zweiten Wärmeableitungsmoduls in thermischem Kontakt mit dem thermoelektrischen Kühler ist.

2. Wärmeableitungssystem nach Anspruch 1, wobei das wenigstens eine erste Wärmeableitungsmodul ferner wenigstens ein wärmeabsorbierendes Element (111), ein wärmeleitendes Element (112) und eine Wärmeableitungsanordnung (130) umfasst, das wenigstens eine wärmeabsorbierende Element in thermischem Kontakt mit der wenigstens einen Wärmequelle ist und das wenigstens eine wärmeabsorbierende Element durch das wärmeleitende Element in thermischem Kontakt mit der Wärmeableitungsanordnung ist.

3. Wärmeableitungssystem nach Anspruch 2, wobei die Wärmeableitungsanordnung ein Gebläse (131) und eine Wärmesenke (133) umfasst, wobei die Wärmesenke der Wärmeableitungsanordnung in thermischem Kontakt mit dem wärmeleitenden Element des wenigstens einen ersten Wärmeableitungsmoduls ist und das Gebläse der Wärmeableitungsanordnung neben der Wärmesenke der Wärmeableitungsanordnung angeordnet ist.

4. Wärmeableitungssystem nach Anspruch 2, wobei das wenigstens eine wärmeabsorbierende Element des wenigstens einen ersten Wärmeableitungsmoduls aus Eisen, Aluminium oder einer Eisen-AluminiumLegierung hergestellt ist.

5. Wärmeableitungssystem nach Anspruch 1, wobei das zweite Wärmeableitungsmodul ferner ein wärmeleitendes Element (420) umfasst, wobei das wärmeleitende Element des zweiten Wärmeableitungsmoduls in thermischem Kontakt mit dem thermoelektrischen Kühler ist und die Wärmesenke des zweiten Wärmeableitungsmoduls durch das wärmeleitende Element des zweiten Wärmeableitungsmoduls in thermischem Kontakt mit dem thermoelektrischen Kühler ist.

6. Wärmeableitungssystem nach Anspruch 5, wobei das wärmeleitende Element des zweiten Wärmeableitungsmoduls wenigstens ein Wärmerohr umfasst.

7. Wärmeableitungssystem nach Anspruch 1, wobei das Gebläse des zweiten Wärmeableitungsmoduls ein Zentrifugalgebläse ist.

8. Wärmeableitungssystem nach Anspruch 7, wobei das Gebläse des zweiten Wärmeableitungsmoduls eine obere Platte (4311), eine untere Platte (4313) und eine seitliche Platte (4315) umfasst, die seitliche Platte zwischen der oberen Platte und der unteren Platte verbunden ist, das Gebläse des zweiten Wärmeableitungsmoduls einen Lufteinlass (S1) und einen Luftauslass (S2) aufweist, der Lufteinlass an der oberen Platte angeordnet ist, der Luftauslass an der seitlichen Platte angeordnet ist und die Wärmesenke des zweiten Wärmeableitungsmoduls benachbart zu dem Luftauslass ist.

## Revendications

1. Système de dissipation de chaleur (1), comprenant :
au moins un premier module de dissipation de chaleur (10) comprenant au moins un premier caloduc (121), l'au moins un premier caloduc (121) ayant une première extrémité et une seconde extrémité opposées l'une à l'autre, la première extrémité étant sur et en contact thermique avec au moins une source de chaleur (91, 92) et située plus près de l'au moins une source de chaleur (91, 92) que la seconde extrémité ;
un second module de dissipation de chaleur (40) comprenant un ventilateur (431) et un dissipateur thermique (433), le ventilateur du second module de dissipation de chaleur étant disposé à côté du dissipateur thermique ; et
un refroidisseur thermoélectrique (30) espacé de l'au moins une source de chaleur (91, 92) et en contact direct avec une plaque de conduction de chaleur (20) qui est en contact direct avec la première extrémité de l'au moins un premier caloduc (121), dans lequel le dissipateur thermique du second module de dissipation de chaleur est en contact thermique avec le refroidisseur thermoélectrique.

2. Système de dissipation de chaleur selon la revendication 1, dans lequel l'au moins un premier module de dissipation de chaleur comprend en outre au moins un élément d'absorption de chaleur (111), un élément de conduction de chaleur (112) et un ensemble de dissipation de chaleur (130), l'au moins un élément d'absorption de chaleur est en contact thermique avec l'au moins une source de chaleur, et l'au moins un élément d'absorption de chaleur est en contact thermique avec l'ensemble de dissipation de chaleur par l'intermédiaire de l'élément de conduction de chaleur.

3. Système de dissipation de chaleur selon la revendication 2, dans lequel l'ensemble de dissipation de chaleur comprend un ventilateur (131) et un dissipateur thermique (133), le dissipateur thermique de l'ensemble de dissipation de chaleur est en contact thermique avec l'élément de conduction de chaleur de l'au moins un premier module de dissipation de chaleur, et le ventilateur de l'ensemble de dissipation de chaleur est disposé à côté du dissipateur thermique de l'ensemble de dissipation de chaleur.

4. Système de dissipation de chaleur selon la revendication 2, dans lequel l'au moins un élément d'absorption de chaleur de l'au moins un premier module de dissipation de chaleur est fait de fer, d'aluminium ou d'un alliage fer-aluminium.

5. Système de dissipation de chaleur selon la revendication 1, dans lequel le second module de dissipation de chaleur comprend en outre un élément de conduction de chaleur (420), l'élément de conduction de chaleur du second module de dissipation de chaleur est en contact thermique avec le refroidisseur thermoélectrique, et le dissipateur thermique du second module de dissipation de chaleur est en contact thermique avec le refroidisseur thermoélectrique par l'intermédiaire de l'élément de conduction de chaleur du second module de dissipation de chaleur.

6. Système de dissipation de chaleur selon la revendication 5, dans lequel l'élément de conduction de chaleur du second module de dissipation de chaleur comprend au moins un caloduc.

7. Système de dissipation de chaleur selon la revendication 1, dans lequel le ventilateur du second module de dissipation de chaleur est un ventilateur centrifuge.

8. Système de dissipation de chaleur selon la revendication 7, dans lequel le ventilateur du second module de dissipation de chaleur comprend une plaque supérieure (4311), une plaque inférieure (4313) et une plaque latérale (4315), la plaque latérale est reliée entre la plaque supérieure et la plaque inférieure, le ventilateur du second module de dissipation de chaleur a une entrée d'air (S1) et une sortie d'air (S2), l'entrée d'air est située sur la plaque supérieure, la sortie d'air est située sur la plaque latérale, et le dissipateur thermique du second module de dissipation de chaleur est adjacent à la sortie d'air.
